Europäisches Patentamt

European Patent Office

Office européen des brevets

(11) Numéro de publication : **0 487 442 A1**

(12) # DEMANDE DE BREVET EUROPEEN

(21) Numéro de dépôt : **91460047.3**

(51) Int. Cl.⁵ : **H04N 7/13**

(22) Date de dépôt : **19.11.91**

(30) Priorité : **20.11.90 FR 9014707**

(43) Date de publication de la demande :
**27.05.92 Bulletin 92/22**

(84) Etats contractants désignés :
**BE CH DE DK ES GB IT LI NL**

(71) Demandeur : **FIET SA**
**Z.A. Sainte-Croix, 1, rue des Tisserands**
**F-35410 Chateaugiron (FR)**

(72) Inventeur : **Desilles, Bertrand**
**2, Allée Guillaume Appolinaire**
**F-35340 Liffre (FR)**
Inventeur : **Robert, Michel**
**12, rue des Logis**
**F-35410 Domloup (FR)**

(74) Mandataire : **Le Guen, Louis François**
**CABINET Louis LE GUEN 38, rue Levavasseur**
**B.P. 91**
**F-35802 Dinard Cédex (FR)**

(54) **Procédé de traitement de données d'image.**

(57)    L'invention concerne un procédé de traitement de données numériques issues du codage de signaux d'images et destinées à être, après traitement, transmises sur un réseau de transmission de données numériques à faible débit du type réseau téléphonique commuté ou spécialisé, lesdites données se présentant sous forme de multiplets de longueur donnée et fixe et forment un fichier de données d'image.

Il consiste essentiellement à substituer à une série S d'au moins quatre multiplets successifs identiques et quelconques mais différents d'un multiplet d'identification ID donné, un mot M de trois multiplets dont un représente le multiplet répété C dans la série S, un autre ledit multiplet d'identification ID et un autre un multiplet N représentant une valeur numérique égale au nombre de multiplets identiques dans la série S moins un.

FIG.3a

EP 0 487 442 A1

L'invention concerne un procédé de traitement de données, en particulier, de données d'image.

On connaît des systèmes qui comportent un site central où l'on génère des images numériques, par exemple, à partir de films, de photographies, d'images de télévision ou d'images de synthèse, et où, une fois ces images délivrées, on les transmet à une pluralité de récepteurs qui les affichent sur des écrans à tube cathodique ou autre.

En général, dans de tels systèmes, ces images se suivent à des intervalles d'au moins quelques secondes entre elles, si bien que l'on parle d'images fixes, ou parfois moins et l'on parle alors d'images animées ou quasi fixes. Elles peuvent néanmoins être transmises sur des réseaux à faible débit, tels que le réseau téléphonique commuté ou des réseaux de ce type.

Pour des raisons diverses, telles que le coût de transmission ou des animations plus rapides, on désire augmenter le nombre d'images transmises par unité de temps, sans pour cela augmenter le débit de transmission sur le réseau.

On sait qu'une image présente des redondances. C'est en particulier le cas lorsque, dans une ligne, une longue série de points de même caractéristique physique apparaissent. On sait également que le codage de la longueur de cette série a pour résultat une compression des données de cette image et donc une augmentation apparente du débit de données.

Le but de l'invention est donc de prévoir un procédé où la longueur d'une série est codée de préférence à la série toute entière, mais qui tienne compte aussi du fait que chaque point de l'image à transmettre est codé sous forme d'un multiplet qui a une longueur fixe.

L'invention concerne donc un procédé de traitement de données numériques d'image consistant:

a) soit à substituer à une série d'au moins quatre multiplets successifs identiques et quelconques mais différents d'un multiplet d'identification donné un mot de trois multiplets dont un représente le multiplet répété dans la série, un autre ledit multiplet d'identification et un autre un multiplet représentant une valeur numérique égale au nombre moins un de multiplets identiques dans la série,

b) soit, dans le cas d'une série de multiplets successifs correspondant audit multiplet d'identification, à ajouter à la fin de ladite série un autre multiplet d'identification,

c) soit, si le nombre de multiplets d'une série d'au moins quatre multiplets successifs identiques et quelconques est égal à la valeur numérique représentée par ledit multiplet d'identification plus un, à substituer à ladite série un mot de trois multiplets dont un est le multiplet répété, un autre le multiplet d'identification, un autre un multiplet représentant une valeur numérique égale au nombre moins deux de multiplets identiques dans la série, ledit mot étant suivi d'un quatrième multiplet égal au multiplet d'identification.

Le cas présenté à l'étape a) est le cas général. On substitue donc par ce procédé à des séries d'au moins quatre multiplets un mot constitué de seulement trois multiplets. Ce procédé de traitement permet donc de compresser le fichier formé par l'ensemble des multiplets. Le fichier compressé peut être décompressé par un récepteur qui dispose de l'information nécessaire à la restitution de la série d'origine: le multiplet à répéter, le nombre de répétitions et la position dans le fichier telle qu'elle est déterminée par le multiplet d'identification.

Le cas prévu à l'étape b) est un cas particulier qui a lieu lorsqu'on est en présence d'une série de multiplets correspondant au multiplet d'identification. Dans ce cas, on ajoute à la fin de la série un multiplet d'identification. A la réception de la nouvelle série le récepteur reçoit le premier multiplet. Il pourrait en déduire qu'il est en présence d'un mot de répétition mais comme ce multiplet est suivi d'un autre multiplet du même type il le considère en réalité comme un multiplet utile. Il procèdera de même jusqu'à l'avant dernier multiplet et arrêtera ce traitement particulier au dernier multiplet de la série.

Le cas c) est également un cas particulier qui a lieu lorsque le nombre de répétitions est égal à la valeur représentée par le multiplet d'identification moins un. Dans ce cas, on procède comme si la série avait une longueur inférieure de deux multiplets à la série réelle, puis on substitue à cette série un mot tel que défini à l'étape a), puis on ajoute un multiplet à la suite de ce mot.

Selon une autre caractéristique de l'invention, le mot de répétition comporte trois multiplets qui se succèdent dans l'ordre suivant: le multiplet répété, le multiplet d'identification et le multiplet représentatif du nombre de multiplets répétés dans la série.

Selon une autre caractéristique de l'invention, le multiplet d'identification est déterminé par balayage dudit fichier et détermination du multiplet dont l'apparition dans le fichier est la moins fréquente.

Cette caractéristique permet d'avoir une faible probabilité, voire une probabilité nulle, d'apparition des cas particuliers b) et c) dans le traitement du fichier.

Selon une autre caractéristique de l'invention, des multiplets parmi tous les multiplets de ladite longueur donnée sont choisis arbitrairement comme ne pouvant constituer ledit multiplet d'identification.

Ainsi certains multiplets qui ont une grande probabilité d'apparaître dans le fichier de par leur nature, multiplet représentant un fond de l'image par exemple, ou multiplet ayant une fonction déterminée dans le système, sont d'emblée exclus comme pouvant servir de multiplet d'identification. Cela permet de faciliter la détermination du multiplet d'identification, en particulier, si cette détermination est faite par balayage du fichier qui devient alors plus rapide.

Selon une autre caractéristique de l'invention, les multiplets sont des octets.

Selon une autre caractéristique de l'invention, le fichier de données traitées comprend, outre les multiplets de données, un en-tête comprenant au moins deux multiplets dont l'un représente une valeur numérique qui est égale au nombre de multiplets que contient ce fichier traité et l'autre correspond au multiplet d'identification ayant servi au traitement des données.

Par cette caractéristique, le récepteur dispose des informations nécessaires à la reconstruction du fichier d'origine.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels:

la Fig. 1 représente un schéma synoptique d'un système de transmission d'images qui utilise le procédé selon l'invention,

la Fig. 2 est une vue qui met en évidence le codage d'une image sous forme d'une suite de multiplets, et

les Figs. 3a à 3c sont des vues qui mettent en évidence le procédé selon l'invention.

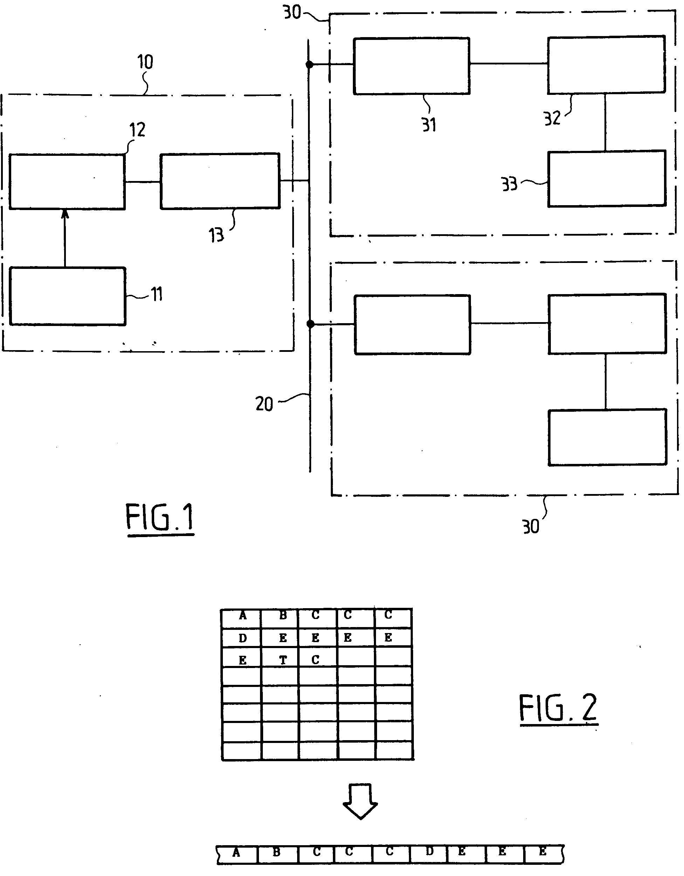

Le système de la Fig. 1 comprend, à un site central 10, une unité 11 de production d'images qui fournit, sur sa sortie, des données numériques d'images. Ces images peuvent être des images de synthèse générées informatiquement par un ordinateur ou proviennent d'images photographiques, filmées ou de télévision qui ont subi un traitement de numérisation.

Les caractéristiques d'un point élémentaire d'une image sont codées sous la forme d'un multiplet et, pour une image donnée, la suite des multiplets correspondant à l'ensemble des points d'image forme un fichier de données. Les caractéristiques codées d'un point élémentaire d'une image sont, par exemple, ses coordonnées dans l'image (numéro de ligne et numéro d'ordre dans la ligne), les amplitudes de luminance et les intensités des couleurs primaires, etc. On notera que les coordonnées dans l'image de chaque point peuvent ne pas être codées et se déduire de l'ordre d'apparition des multiplets dans le fichier.

On a représenté schématiquement, à la Fig. 2, le processus de codage d'une image en une suite de multiplets.

Les multiplets sont avantageusement des octets ou des mots de seize bits. Cela permet en effet l'utilisation de composants standard pour la réalisation des différentes unités composant le système.

La sortie de l'unité 11 est reliée à une entrée d'une unité de traitement 12 dont la sortie est reliée à l'entrée d'un modem 13. La sortie de celui-ci est raccordée à un réseau 20 qui peut être du type téléphonique commuté ou spécialisé.

Sur le réseau 20, sont également raccordés des récepteurs 30 (deux seulement sont visibles sur la Fig. 1). Chaque récepteur 30 comprend un modem 31 dont la sortie est reliée à l'entrée d'une unité de traitement 32, la sortie de celle-ci étant reliée à une unité d'affichage d'images 33. L'unité 33 est conçue pour recevoir des données d'images numériques dans le même format que celles délivrées par l'unité de production 11 et les afficher sur un écran de type télévision ou autre.

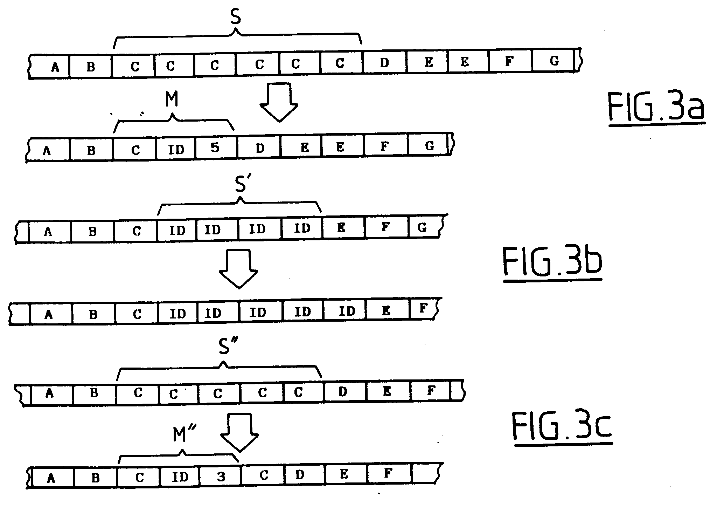

L'unité de traitement 12 reçoit les données d'image de l'unité 11 sous forme d'une suite d'un certain nombre de multiplets correspondant au nombre de points élémentaires dans cette image, comme cela a déjà été décrit. Le fonctionnement de l'unité 12 est le suivant. Il consiste à substituer à une série d'au moins quatre multiplets successifs identiques et quelconques $\underline{S}$ (Fig. 3a) un mot $\underline{M}$ de trois multiplets dont un $\underline{C}$ représente le multiplet répété dans la série $\underline{S}$, un autre ID qui est un multiplet d'identification et un autre $\underline{N}$ (= 5 à la Fig. 3a) qui représente une valeur numérique égale au nombre de multiplets identiques dans la série $\underline{S}$ moins un. Selon un mode de réalisation, les trois multiplets $\underline{C}$, $\underline{M}$, $\underline{N}$ se succèdent dans cet ordre dans la suite résultante.

On notera que le multiplet ID fait partie de l'ensemble de tous les multiplets qu'il est possible de former. Par exemple, avec des octets, l'octet d'identification ID fait partie de l'ensemble des 256 octets possibles. Avec des multiplets à seize bits, il fait partie des 65 536 possibles.

Le multiplet d'identification ID est choisi arbitrairement préalablement au traitement de substitution. Il peut également être déterminé par balayage du fichier de données et par détermination du multiplet ou des multiplets dont l'apparition est la moins fréquente, puis éventuellement par choix arbitraire ou non parmi les multiplets de faible probabilité d'apparition d'un multiplet.

Certains multiplets peuvent être interdits en tant que multiplet d'identification, de par leur nature ou de leur fonction particulière dans le système.

L'unité de traitement 12 procède autrement dans le cas d'une série $\underline{S}'$ de multiplets successifs correspondant au multiplet d'identification ID choisi. On ajoute alors, à la fin de la série $\underline{S}'$, un autre multiplet d'identification ID (Fig. 3b).

L'unité de traitement 12 gère aussi le cas où le nombre de multiplets d'une série $\underline{S}''$ (Fig. 3c) est égal à la valeur à laquelle correspond le multiplet d'identification ID choisi plus un. Supposons que la valeur correspondant au multiplet d'identification soit quatre et que la longueur de la série $\underline{S}''$ soit de cinq comme cela est montré à la Fig. 3c. On considère, dans un premier temps, une série de longueur égale à la longueur moins un de la série $\underline{S}''$, c'est-à-dire ici 5 - 1 = 4, et on forme alors le mot $\underline{M}''$ correspondant et

comprenant le multiplet C̲ répété dans la série S̲″, le multiplet d'identification I̲D̲ et un multiplet représentatif de la longueur moins un de la série considérée, c'est-à-dire le nombre N - 1 (soit ici (5 - 1) - 1 = 3). Dans un second temps, on ajoute un multiplet C̲ semblable à celui de la série d'origine S̲″.

Une fois ce traitement effectué, l'unité 12 crée un en-tête comprenant deux multiplets. Le premier indique le nombre de multiplets dans le fichier traité, et le second est le multiplet d'identification.

Le fichier traité avec cet en-tête est alors transmis, au moyen du modem 13 sur le réseau 20 où il est reçu par les récepteurs 30. Là, chaque modem 31 reçoit les signaux sur le réseau et délivre une suite de multiplets correspondant au fichier transmis. Cette suite est fournie à l'unité 32.

L'unité 32 fonctionne à l'inverse de l'unité de traitement 12. Deux cas peuvent se présenter à elle.

Dans le premier cas, dans la suite de multiplets qu'elle reçoit du modem 31, apparaît une suite de trois multiplets dont le deuxième est le multiplet d'identification. Elle génère alors une série de multiplets correspondant au premier multiplet de cette suite et en nombre égal à la valeur correspondant au troisième multiplet plus un.

Dans le second cas, elle reçoit un premier multiplet d'identification. Elle pourrait construire une série comme précédemment, mais la longueur de cette série, telle que donnée par le troisième multiplet, est aussi un multiplet d'identification. Elle considère alors le premier multiplet d'identification comme pertinent et ce jusqu'à ce qu'un multiplet autre que le multiplet d'identification apparaisse.

On remarquera que le cas où le nombre de multiplets dans une série est égal à la valeur à laquelle correspond le multiplet d'identification plus un se ramène, pour l'unité de traitement 32, au premier cas ci-dessus.

Notons encore que l'unité de traitement 32 traite, préalablement à ce traitement de remise en forme des séries, l'en-tête du fichier correspondant à l'image transmise.

Une fois le traitement de remise en forme effectué, l'unité 32 fournit à l'unité d'affichage 33 le fichier de données et celle-ci affiche l'image correspondante.

**Revendications**

1) Procédé de traitement de données numériques issues du codage de signaux d'images et destinées à être, après traitement, transmises sur un réseau de transmission de données numériques à faible débit du type réseau téléphonique commuté ou spécialisé, lesdites données se présentant sous forme de multiplets de longueur donnée et fixe et forment un fichier de données d'image, caractérisé en ce qu'il consiste:

a) soit à substituer à une série S̲ d'au moins quatre multiplets successifs identiques et quelconques mais différents d'un multiplet d'identification ID donné, un mot M̲ de trois multiplets dont un représente le multiplet répété C̲ dans la série S̲, un autre ledit multiplet d'identification ID et un autre un multiplet N̲ représentant une valeur numérique égale au nombre de multiplets identiques dans la série S̲ moins un,

b) soit, dans le cas d'une série S̲′ de multiplets successifs correspondant audit multiplet d'identification ID, à ajouter à la fin de ladite série S̲′ un autre multiplet d'identification ID,

c) soit, si le nombre de multiplets d'une série S̲″ d'au moins quatre multiplets successifs identiques et quelconques est égal à la valeur numérique représentée par ledit multiplet d'identification ID plus un, à substituer à ladite série S̲″ un mot M̲″ de trois multiplets dont un est le multiplet répété C̲, un autre le multiplet d'identification ID, un autre un multiplet représentant une valeur numérique égale au nombre moins deux de multiplets identiques dans la série S̲″, ledit mot M̲″ étant suivi d'un quatrième multiplet égal au multiplet d'identification.

2) Procédé selon la revendication 1, caractérisé en ce que les trois multiplets d'un mot M̲ ou M̲″ à l'étape a ) ou à l'étape c) se suivent dans l'ordre suivant: le multiplet répété C̲, le multiplet d'identification ID et le multiplet N̲ représentatif du nombre ou du nombre moins un de multiplets répétés dans la série S̲ ou S̲″.

3) Procédé selon la revendication 1 ou 2, caractérisé en ce que le multiplet d'identification ID est déterminé par balayage dudit fichier et détermination du multiplet dont l'apparition dans le fichier est la moins fréquente.

4) Procédé selon la revendication 1, 2 ou 3, caractérisé en ce que des multiplets parmi tous les multiplets de ladite longueur donnée sont choisis arbitrairement comme ne pouvant constituer ledit multiplet d'identification.

5) Procédé selon une des revendications précédentes, caractérisé en ce que les multiplets sont des octets.

6) Procédé selon une des revendications précédentes, caractérisé en ce que le fichier de données traitées comprend, outre les multiplets de données, un en-tête comprenant au moins deux multiplets dont l'un représente une valeur numérique qui est égale au nombre de multiplets que contient le fichier traité et l'autre correspond au multiplet d'identification ayant servi au traitement des données.

FIG.1

| A | B | C | C | C |
|---|---|---|---|---|
| D | E | E | E | E |
| E | T | C |   |   |
|   |   |   |   |   |
|   |   |   |   |   |
|   |   |   |   |   |
|   |   |   |   |   |
|   |   |   |   |   |

FIG.2

| A | B | C | C | C | D | E | E | E |
|---|---|---|---|---|---|---|---|---|

FIG.3a

FIG.3b

FIG.3c

EP 0 487 442 A1

**Office européen des brevets**

# RAPPORT DE RECHERCHE EUROPEENNE

Numero de la demande

EP  91 46 0047

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-4 626 829  (E.L. HAUCK)<br>* Colonne 5, ligne 60 - colonne 6, ligne 62; colonne 10, lignes 13-58 *<br>--- | 1-3,5 | H 04 N   7/13 |
| Y | GB-A-2 168 871  (BBC)<br>* Résumé; page 1, ligne 5 - page 2, ligne 47 *<br>--- | 1-3,5 | |
| A | US-A-4 684 923  (TOSHIO KOGA)<br>* Colonne 6, ligne 52 - colonne 7, ligne 31 *<br>--- | 1,4 | |
| A | EP-A-0 339 948  (UVC CORP.)<br>* Figure 1 *<br>----- | 1 | |

**DOMAINES TECHNIQUES RECHERCHES (Int. Cl.5)**

H 04 N
H 03 M

Le présent rapport a été établi pour toutes les revendications

| Lieu de la recherche | Date d'achèvement de la recherche | Examinateur |
|---|---|---|
| LA HAYE | 03-02-1992 | BOSCH F.M.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant